# EUROPEAN PATENT SPECIFICATION

(11) **EP 3 992 670 B1**
(45) Date of publication and mention of the grant of the patent: **04.06.2025**
(21) Application number: 20924984.6
(22) Date of filing: 07.09.2020
(51) Int. Cl.: G01V 3/08, H03K 17/955, H03K 17/96

(54) **PROXIMITY DETECTION APPARATUS AND ELECTRONIC DEVICE**
NÄHERUNGSERKENNUNGSGERÄT UND ELEKTRONISCHE VORRICHTUNG
APPAREIL DE DÉTECTION DE PROXIMITÉ ET DISPOSITIF ÉLECTRONIQUE

(43) Date of publication of application: 04.05.2022
(73) Proprietor: SHENZHEN GOODIX TECHNOLOGY CO., LTD., Shenzhen, Guangdong 518045 (CN)
(72) Inventor: LI, Ke, Guangdong 518045 (CN); YANG, Ming, Guangdong 518045 (CN); CHEN, Dansheng, Guangdong 518045 (CN)
(74) Representative: Kraus & Lederer PartGmbB
(86) International application number: PCT/CN2020/113786
(87) International publication number: WO 2022/047789

(56) References cited:
- CN-A- 104 122 974
- CN-A- 104 769 446
- CN-U- 201 707 661
- JP-A- 2014 203 205
- JP-A- 2014 203 205
- US-A1- 2014 015 595
- US-A1- 2018 069 549
- US-A1- 2019 250 737

## Description

### TECHNICAL FIELD

Embodiments of the present application relate to the field of capacitance detection, and more specifically, to an approaching detection apparatus and an electronic device.

### BACKGROUND

Electronic devices, such as wearable devices, bring people a rich user experience. With the development of intelligence, detecting whether a wearable device is worn by a human body has gradually become a standard function of the wearable device. The traditional solution can configure a detection module in the wearable device to detect whether the human body wears the device. However, the traditional detection method is easily affected by the approaching of a non-human body such as water or sweat. For example, when water remains on the device, it is easy to misjudge the water approaching the device as the device being worn by the human body, which will affect the user experience.

Therefore, how to accurately detect user's approaching to the electronic device has become a problem urgently to be solved.

JP2014203205A is directed to a capacitance detection device. The capacitance detection device includes: a plurality of drive electrodes to which driving voltage is applied; a plurality of sense electrodes which are capacitively coupled with the plurality of drive electrodes; a measurement part for measuring mutual capacitance of the plurality of drive electrodes and the plurality of sense electrodes; a control part which sets the mutual capacitance value measured by the measurement part at a prescribed timing as a reference value and monitors a following variation of mutual capacitance value with respect to the reference value; and a storage part for storing the integration value of each sense electrode when the variation in the mutual capacitance measured by the measurement part is equal to or greater than a first threshold TH1. When the variation of the mutual capacitance and the integration value stored in the storage part correspond in positive/negative reverse with respect to a reference value, the control part resets the mutual capacitance value measured again by the measurement part as the reference value.

US20140015595A1 is directed to a capacitive body proximity sensor system. The system can detect the proximity of an object and differentiate between a human body and a non-human object. The detection and differentiation are facilitated by a first capacitive sensor of a first shape and a second capacitive sensor of a second shape. The detection and determination can be made based on a comparison between a first capacitance from the first sensor and a second capacitance from the second sensor. For example, the electronic component 116 of the system can employ a proximity detection algorithm (stored in the memory and executed by the processor) that utilizes the first capacitance, the second capacitance, the difference between the first capacitance and the second capacitance, and the ratio between the first capacitance and the second capacitance to sense proximity of the object 102 and/or to facilitate determination of whether the object 102 is a human body or an inanimate object.

US20190250737A1 is directed to a capacitive touch / proximity sensor with integrated ultra-high frequency antenna, which includes a capacitive touch sensor having a copper trace defining a capacitive electrode. The copper trace has a saw - tooth configuration. An ultra - high frequency (UHF) antenna is provided. A metal ground plane integrates the capacitive touch sensor with the UHF antenna. The saw tooth copper trace aids in reducing interference with the UHF antenna.

US20180069549A1 is directed to a capacitive proximity sensor for detecting proximity of a body portion to a mobile device, comprising: a plurality of capacitive sensing electrodes for detecting said body portion, an electronic processing circuit arranged for measuring the capacities of said capacitive sensing electrodes and for generating a proximity signal based on the capacities so measured, wherein the capacitive sensing electrodes are connected together by one or more capacitive element , and at least one capacitive sensing electrode is connectable to a radio circuit of said mobile device so as to constitute a radiofrequency antenna of said mobile device. Wherein, capacitive sensors may use, as sense electrode, a conductive layer on a printed circuit board or PCB. In the example, the electrode is surrounded by a grounded ring, backed by a shield electrode, and covered by a dielectric overlay.

### SUMMARY

Embodiments of the present application provide an approaching detection apparatus and an electronic device, which are beneficial to improving the distinction between a human body approaching the electronic device and a non-human body approaching the electronic device.

An approaching detection apparatus and an electronic device comprising the approaching detection apparatus as defined in the claims are provided.

Based on the above technical solution, the mutual capacitance detection enables the variations in the mutual capacitance value due to the approaching of the human body and the non-human body to be one positive and one negative, that is, the directions of the variations in the mutual capacitance value due to the approaching of the human body and the non-human body are just opposite. For example, the mutual capacitance value decreases when the human body approaches, but the mutual capacitance value increases when the non-human body approaches, or the mutual capacitance value increases when the human body approaches, but the mutual capacitance value decreases when the non-human body approaches. As such, the distinction between the human body and the non-human body can be improved. The detection module only needs to detect whether the mutual capacitance value increases or decreases, and then it can be determined whether the human body approaches the electronic device or the non-human body approaches the electronic device. This can identify the approaching state of the electronic device more easily, and is beneficial to reducing the misjudgment rate.In a possible implementation, the first electrode and the second electrode are arranged in the same plane; or the first electrode and the second electrode are arranged in parallel, the first electrode is arranged above the second electrode, and projections of the first electrode and the second electrode in a direction perpendicular to a surface of the first electrode do not overlap, or projection of a part of the second electrode overlaps with projection of the first electrode in a direction perpendicular to the surface of the first electrode overlap.

When an external object approaches the electronic device, in the approaching direction facing the human body, the first electrode does not shield the second electrode or only partially shields the second electrode to ensure that both the first electrode and the second electrode can form a capacitance with the external object.

In a possible implementation, the first electrode and the second electrode are arranged in the same plane, the first electrode is arranged in a middle area of the second electrode, and the second electrode is of a ring structure surrounding the first electrode.

The arrangement in a ring-shaped pattern can increase the coupling length between the first electrode and the second electrode, and can increase the amount of signals sensed between the first electrode and the second electrode.

In a possible implementation, the first electrode and the second electrode are concentrical.

The concentrical first electrode and second electrode ensure that the gap between the two electrodes at different positions is equal, so that no matter at which position the external object approaches the electronic device, the signal sensing amount between the first electrode and the second electrode is relatively uniform, that is, the magnitude of the signal sensing amount is identical.

In a possible implementation, the first electrode is of a rectangular structure, and the second electrode is of a square ring structure surrounding the first electrode.

Generally, a substrate carrying the approaching detection apparatus is rectangular, and the rectangular electrodes can improve the space utilization of the substrate. In addition, considering that the approaching area of the human body approaching the electronic device is usually rectangular, the rectangular electrodes can more fully sense the influence of the human body on mutual capacitance signals.

In a possible implementation, a width of the second electrode is greater than or equal to a gap between the first electrode and the second electrode.

The ring width of the second electrode is greater than or equal to the gap between the two electrodes, which is beneficial to ensuring a relatively small difference between an absolute value when the variation of the mutual capacitance value is a positive value and an absolute value when the variation of the mutual capacitance value is a negative value, thereby improving the accuracy of the detection result that the human body approaches the electronic device.

In a possible implementation, a gap between the first electrode and the second electrode is L/6 to L/4, where L is the length of a long side of the first electrode, which is beneficial to ensuring a relatively small difference between the absolute value when the variation of the mutual capacitance value is a positive value and the absolute value when the variation of the mutual capacitance value is a negative value, thereby improving the accuracy of the detection result that the human body approaches the electronic device.

In a possible implementation, a width of the second electrode is greater than or equal to 0.2 mm to ensure that there is a sufficient signal sensing amount between the second electrode and the human body.

In a possible implementation, the first electrode and the second electrode are arranged in the same plane, the first electrode and the second electrode are arranged in a meshing structure, the first electrode includes a first toothed structure, the second electrode includes a second toothed structure, and the first toothed structure meshes with the second toothed structure.

The solution of arrangement in a meshing structure can increase the coupling length between the first electrode and the second electrode, and can increase the amount of signals sensed between the first electrode and the second electrode.

In a possible implementation, a tooth width of the first toothed structure is equal to a tooth width of the second toothed structure.

The equal tooth width of the two toothed structures can ensure that the first electrode and the second electrode have an equal area, so that the first electrode and the second electrode have an equal signal sensing amount with the human body.

In a possible implementation, a gap between the first electrode and the second electrode is q/3 to q/2, where q is the tooth width of the first electrode or the second electrode, which is beneficial to ensuring a relatively small difference between the absolute value when the variation of the mutual capacitance value is a positive value and the absolute value when the variation of the mutual capacitance value is a negative value, thereby improving the accuracy of the detection result that the human body approaches the electronic device.

In a possible implementation, the first electrode meshes with the second electrode by two or three teeth.

The two or three meshing teeth are beneficial to avoiding too small tooth widths of the first electrode and the second electrode, and are also beneficial to the manufacturing and installation of the first electrode and the second electrode.

In a possible implementation, a third electrode is further included, the first electrode and the second electrode are arranged in the same plane, and the third electrode is arranged below the first electrode and is parallel to the first electrode.

By adding the third electrode which can absorb some electric field lines between the first electrode and the second electrode, it is easier to achieve the purpose that the variations in the mutual capacitance value caused by the approaching of the human body and the approaching of the non-human body are just in opposite directions.

In a possible implementation, projection of the third electrode in a direction perpendicular to a surface of the third electrode at least covers projection of a gap between the first electrode and the second electrode in the direction perpendicular to the surface of the third electrode.

The projection of the third electrode covers the gap between the first electrode and the second electrode, which can ensure that the third electrode has a sufficient influence on the electric field lines between the first electrode and the second electrode.

In a possible implementation, an edge of the third electrode is aligned with an edge of a pattern formed by the first electrode and the second electrode. This facilitates the encapsulation of the first electrode, the second electrode, and the third electrode.

In a possible implementation, a distance between the third electrode and the first electrode is less than or equal to 200 µm, which can avoid a too long distance between the third electrode and the first electrode and can ensure the influence of the third electrode on the electric field lines between the first electrode and the second electrode.

In a possible implementation, a distance between the third electrode and the first electrode is less than or equal to 100 µm, which can avoid a too long distance between the third electrode and the first electrode and can ensure the influence of the third electrode on the electric field lines between the first electrode and the second electrode.

In a possible implementation, the first electrode and the second electrode are arranged in parallel, and the third electrode and the second electrode are arranged in the same plane.

The third electrode and the second electrode are coplanar, which can ensure the influence of the third electrode on the electric field lines between the first electrode and the second electrode.

In a possible implementation, a distance between the third electrode and the first electrode is less than or equal to 100 µm, which not only can ensure a sufficient signal sensing amount between the first electrode and the second electrode, but also can ensure the influence of the third electrode on the electric field lines between the first electrode and the second electrode.

The first capacitance, the second capacitance, and the third capacitance can affect the variation of the mutual capacitance value. Therefore, in the present application, one of the first variation and the second variation can be a positive value and the other of the first variation and the second variation can be a negative value by adjusting capacitance values of the first capacitance, the second capacitance, and the third capacitance.

In a possible implementation, the detection module is further configured to detect a variation of a self-capacitance value of the first electrode and/or the second electrode, where it is determined that the external object approaches the electronic device when the variation of the self-capacitance value is greater than a preset threshold, and the detection module detects the variation of the mutual capacitance value between the first electrode and the second electrode when the variation of the self-capacitance value is greater than the preset threshold.

By combining the advantages of self-capacitance detection and mutual capacitance detection, the present application adopts self-capacitance and mutual capacitance integrated detection, which can further improve the accuracy of the detection result that the human body approaches the electronic device.

In a second aspect, an electronic device is provided, including: the approaching detection apparatus in the first aspect or any of the possible implementations of the first aspect.

The invention is set out in the appended set of claims.

### BRIEF DESCRIPTION OF THE DRAWINGS

FIG. 1 is a schematic diagram of a traditional self-capacitance detection mode.
FIG. 2 is a schematic diagram of an approaching detection apparatus according to an embodiment of the present application.
FIG. 3 is a schematic diagram of capacitances produced on the approaching detection apparatus when an external object approaches according to an embodiment of the present application.
FIG. 4 is a schematic diagram of a capacitance produced between a first electrode and a second electrode when an external object approaches according to an embodiment of the present application.
FIG. 5 is a schematic diagram of a homocentric-squares electrode structure according to an embodiment of the present application.
FIG. 6 is a schematic diagram of another homocentric-squares electrode structure according to an embodiment of the present application.
FIG. 7 is a cross-sectional view of a homocentric-squares electrode structure according to an embodiment of the present application.
FIG. 8 is a cross-sectional view of another homocentric-squares electrode structure according to an embodiment of the present application.
FIG. 9 is a schematic diagram of a meshing electrode structure according to an embodiment of the present application.
FIG. 10 is a schematic diagram of another meshing electrode structure according to an embodiment of the present application.
FIG. 11 is a schematic diagram of electric field lines induced between an electrode and a system ground during self-capacitance induction.
FIG. 12 is a schematic diagram of electric field lines induced between the first electrode, the second electrode and the system ground during mutual capacitance induction.

### DETAILED DESCRIPTION

The technical solutions in the embodiments of the present application will be described below in conjunction with the accompanying drawings.

The electronic device in the embodiments of the present application may be a smart wearable device, a smart pen, a gamepad, or other capacitive touch product. The smart wearable device may be, for example, a headset, a watch, a bracelet, etc.

The following describes the headset as an example.

In recent years, with the development of wireless and intelligent headsets, in-ear detection has gradually become a standard function of smart wireless headsets. A headset with in-ear detection function can monitor in real time whether the headset is worn or separated from the human ear, and its working state is switched by means of this information. For example, during music playback, when it is identified that the user takes off the headset, the music will be paused immediately; and when it is identified that the headset is put into the ear again, the music will be automatically continued. For another example, if the user takes off the headset during a call, the call will be seamlessly switched to a phone channel.

Mainstream front-end sensors for in-ear detection are capacitive and optical. Among them, the capacitance solution does not require a hole, has significant advantages in appearance, dust-proof and water-proof performance, etc., and therefore has a broader prospect. However, the traditional capacitance detection solution has always had the defect of easy disturbance by water, sweat and temperature.

Traditional wearing detection (or human approaching sensing) methods generally use self-capacitance detection, that is, detecting a self-capacitance value of an electrode to a system ground, and determining according to the variation of the self-capacitance value whether the user is wearing a wearable device.

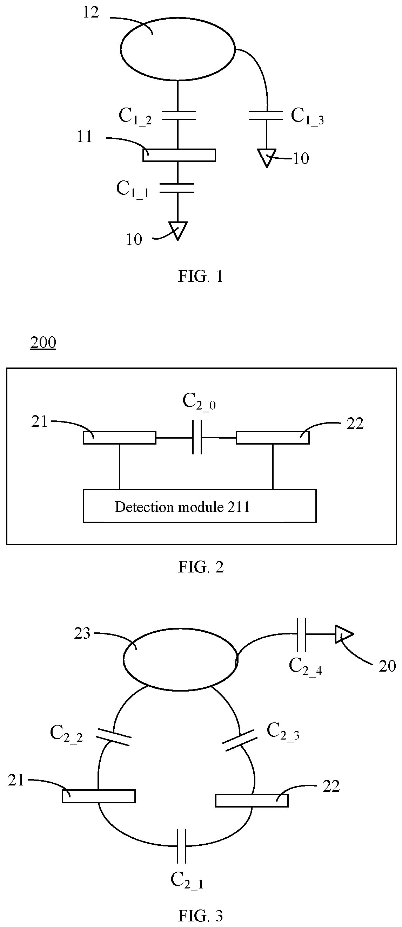

Taking FIG. 1 as an example, the electrode 11 is a self-capacitance electrode, and the electrode 11 has a base capacitance C_{1_1} to a system ground 10. When an external object 12 approaches, two more capacitances C_{1_2} and C_{1_3} will be introduced. The capacitance C_{1_2} is a capacitance between the external object 12 and the electrode 11, and the capacitance C_{1_3} is a capacitance between the external object 12 and the system ground 10. When the external object 12 approaches, the total capacitance of the electrode 11 to the system ground 10 increases, and the increment is approximately the series connection of the capacitance C_{1_2} and the capacitance C_{1_3}. Therefore, in the self-capacitance detection mode, the distinction between a human body and a non-human body is mainly derived from the difference in the result of the series connection of the capacitance C_{1_2} and the capacitance C_{1_3}.

With regard to the self-capacitance detection, whichever of the human body and the water or sweat approaches, the total capacitance of the electrode 11 to the system ground 10 increases. However, due to the discreteness of human body wearing and the diversity and uncertainty of sweat form, the increments in the total capacitance caused by the human body and the water or sweat have an ambiguous interval that is difficult to distinguish, that is, when the increment in the total capacitance is detected in this ambiguous interval, the increment may be caused by the human body wearing the electronic device, or may be caused by residual water or sweat. Therefore, in many cases, the increments in the total capacitance caused by the human body and the water or sweat are difficult to distinguish, so that the water or sweat remaining on the device is easily misjudged as human body wearing.

On this basis, an embodiment of the present application provides an approaching detection apparatus, which enables the directions of mutual capacitance signal variations caused by a human body and a non-human body to be opposite, and can effectively improve the distinction between human body approaching and non-human body approaching, thereby improving the accuracy of the detection result that the human body approaches an electronic device and improving user experience. The non-human body in the embodiment of the present application can be various conductive media, such as water or sweat. When a user wears a wearable device, water or sweat easily remains on the wearable device.

The approaching detection apparatus according to the example not forming part of the claimed invention can be used in an electronic device. The apparatus can include a first electrode, a second electrode, and a detection module. The detection module is electrically connected to the first electrode and the second electrode, and is configured to detect a variation of a mutual capacitance value between the first electrode and the second electrode, the variation of the mutual capacitance value being used to determine an approaching state of the electronic device. When a human body approaches the electronic device, the variation of the mutual capacitance value is a first variation, and when a non-human body approaches the electronic device, the variation of the mutual capacitance value is a second variation, one of the first variation and the second variation being a positive value and the other of the first variation and the second variation being a negative value.

The first electrode and the second electrode are arranged in the same plane; or the first electrode and the second electrode are arranged in parallel, the first electrode is arranged above the second electrode, and projections of the first electrode and the second electrode in a direction perpendicular to a surface of the first electrode do not overlap, or projections of a part of the second electrode and the first electrode in a direction perpendicular to a surface of the first electrode overlap.

Since one of the variations of the mutual capacitance value when the external objects are a human body and a non-human body is a positive value and the other of the variations of the mutual capacitance value when the external objects are a human body and a non-human body is a negative value, that is, the variations of the mutual capacitance value caused by the two are opposite in direction, the distinction between the human body and the non-human body can be improved. The detection module only needs to detect whether the variation of the mutual capacitance value is positive or negative to determine whether the human body approaches the device or the non-human body approaches the device, which can easily identify whether the device is approached by the human body, and is thus beneficial to reducing the misjudgment rate. For example, it can be accurately identified whether a headset is worn by a user, whether a stylus is held by a user, whether a gamepad is held by a user, etc., so that the electronic device performs a corresponding control operation according to whether it is approached by the human body to improve user experience.

For the convenience of description, the human body and the non-human body are collectively referred to as an external object below.

A first capacitance is formed between the first electrode and an external object, a second capacitance is formed between the second electrode and the external object, and a third capacitance is formed between a system ground and the external object, wherein the external object includes a human body and a non-human body, and the first capacitance, the second capacitance, and the third capacitance enable one of the first variation and the second variation to be a positive value, and the other of the first variation and the second variation to be a negative value.

The first capacitance, the second capacitance, and the third capacitance can affect the variation of the mutual capacitance value greatly. Therefore, in the embodiment of the present application, one of the first variation and the second variation can be a positive value and the other of the first variation and the second variation can be a negative value by adjusting capacitance values of the first capacitance, the second capacitance, and the third capacitance.

As an example, when the external object is a human body, the first capacitance, the second capacitance, and the third capacitance enable the first variation to be positive; and when the external object is a non-human body, the first capacitance, the second capacitance, and the third capacitance enable the second variation to be negative.

As an example, when the external object is a human body, the first capacitance, the second capacitance, and the third capacitance enable the first variation to be negative; and when the external object is a non-human body, the first capacitance, the second capacitance, and the third capacitance enable the second variation to be positive.

The non-human body in the embodiment of the present application can be a conductor, and the conductor can be a liquid, such as water or sweat.

The approaching detection apparatus according to the embodiment of the present application can also be referred to as a contact detection apparatus. The mutual capacitance value between the first electrode and the second electrode can vary when an external object contacts the electronic device. However, in some cases, the mutual capacitance value between the first electrode and the second electrode can also vary when an external object is relatively close to the electronic device but does not contact the electronic device.

A solution according to the embodiment of the present application will be described in detail below with reference to FIGS. 2 to 4.

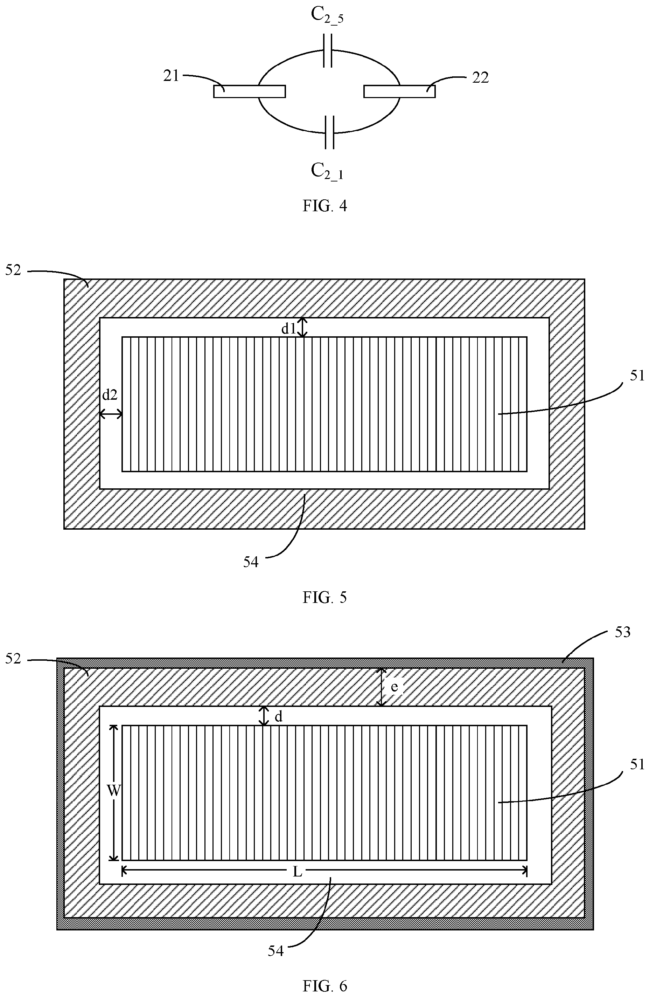

FIG. 2 shows induction between a first electrode 21 and a second electrode 22 when no external object approaches; FIG. 3 shows induction between the first electrode 21, the second electrode 21, an external object 23, and a system ground 20 when the external object approaches; and FIG. 4 shows that equivalent capacitances are formed between two electrodes due to the approaching of an external object.

The approaching detection apparatus 200 can include a first electrode 21, a second electrode 22, and a detection module 211. The detection module 211 is configured to detect a variation of a mutual capacitance value between the first electrode 21 and the second electrode 22, the variation of the mutual capacitance value being used to determine whether the human body approaches the electronic device.

The detection module can detect the variation of the mutual capacitance value between the first electrode and the second electrode. For example, the detection module can detect a mutual capacitance between the first electrode and the second electrode as a base capacitance when the external object does not approach the electronic device, and detect a first mutual capacitance value between the first electrode and the second electrode during subsequent approaching detection, and a processor can calculate the difference between the first mutual capacitance value and the base capacitance, and use the difference as the variation of the mutual capacitance value.

According to the embodiment of the present application, one of the variations of the mutual capacitance value caused when the human body and the non-human body approach the electronic device can be a positive value, and the other of the variations of the mutual capacitance value caused when the human body and the non-human body approach the electronic device can be a negative value by enabling the decrease in the original mutual capacitance between the first electrode and the second electrode and the equivalent capacitance between the first electrode and the second electrode to satisfy: equivalent capacitance (human body) < original mutual capacitance decrease < equivalent capacitance (non-human body), or equivalent capacitance (non-human body) < original mutual capacitance decrease < equivalent capacitance (human body). That is, the equivalent capacitance produced when the human body approaches and the equivalent capacitance produced when the non-human body approaches are located on two sides of the original mutual capacitance decrease, so that one of the variations of the mutual capacitance value caused when the human body and the non-human body approach is a positive value and the other of the variations of the mutual capacitance value caused when the human body and the non-human body approach is a negative value.

The equivalent capacitance can be understood as a capacitance with equal capacitance effect formed between the first electrode and the second electrode by the first capacitance, the second capacitance, and the third capacitance. The original mutual capacitance decrease can be understood as the variation of the mutual capacitance value between the first electrode and the second electrode without the equivalent capacitance. The equivalent capacitance (human body) indicates an equivalent capacitance formed between the first electrode and the second electrode by the first capacitance, the second capacitance, and the third capacitance because the human body approaches the electronic device, and the equivalent capacitance (non-human body) indicates an equivalent capacitance formed between the first electrode and the second electrode by the first capacitance, the second capacitance, and the third capacitance because the non-human body approaches the electronic device.

Since the actual variation of the mutual capacitance value between the first electrode and the second electrode is the difference between the equivalent capacitance and the original mutual capacitance decrease, if the equivalent capacitance is less than the original mutual capacitance decrease, the difference between the two is less than zero, and if the equivalent capacitance is greater than the original mutual capacitance decrease, the difference between the two is greater than zero. Therefore, when the equivalent capacitance produced when the human body approaches (i.e. the above-mentioned equivalent capacitance (human body)) and the equivalent capacitance produced when the non-human body approaches (i.e. the above-mentioned equivalent capacitance (non-human body)) are located on two sides of the original mutual capacitance decrease, one of the actual variations of the mutual capacitance value between the first electrode and the second electrode is a positive value and the other of the actual variations of the mutual capacitance value between the first electrode and the second electrode is a negative value, so that the purpose of improving the distinction between the human body and the non-human body can be achieved.

Taking FIGS. 2 to 4 as an example, the electrode 21 and the electrode 22 are respectively a first electrode and a second electrode, and there is a base capacitance C_{2_0} between the electrode 21 and the electrode 22 when no external object approaches. When the external object 23 approaches, the external object 23 as a conductor causes some charges in the base capacitance C_{2_0} to flow to the system ground 20, so the capacitance C_{2_0} decreases and becomes capacitance C_{2_1}, that is, C_{2_1} = C_{2_0} - ΔC, where ΔC is the original mutual capacitance decrease, and does not represent the actual decrease. Theoretically, as long as the original mutual capacitance decrease ΔC is detected, it can be determined whether the external object approaches the electronic device, but when the external object 23 approaches, the first capacitance C_{2_2}, the second capacitance C_{2_3}, and the third capacitance C_{2_4} are introduced. The three capacitances form an equivalent capacitance C_{2_5} between the electrode 21 and the electrode 22, and the equivalent capacitance affects the actual detected variation of the mutual capacitance value. In the presence of the equivalent capacitance C_{2_5}, the actually detected mutual capacitance value between the two electrodes is a parallel connection of the capacitance C_{2_1} and the equivalent capacitance C_{2_5}, as shown in FIG. 4, that is, the actually detected mutual capacitance value is (C_{2_0} - ΔC + C_{2_5}), where the first capacitance C_{2_2} is a capacitance between the external object 23 and the electrode 21, the second capacitance C_{2_3} is a capacitance between the external object 23 and the electrode 22, and the third capacitance C_{2_4} is a capacitance between the external object 23 and the system ground 20.

Since C_{2_0} is the base capacitance, the actual detected variation of the mutual capacitance value between the electrode 21 and the electrode 22 is (C_{2_5} - ΔC).

According to the embodiment of the present application, by adjusting the magnitudes of the original mutual capacitance decrease ΔC and the equivalent capacitance C_{2_5}, C_{2_5(human} body) < ΔC < C_{2_5(non-human body)}, or C_{2_5(non-human body)} < ΔC < C_{2_5(human body)}, so that one of the variations of the mutual capacitance value is a positive value and the other of the variations of the mutual capacitance value is a negative value.

In the embodiment of the present application, the external object 23 can be a human body or any conductive non-human body. The non-human body can be, for example, water or sweat. The human body or the water or sweat as a conductor will affect the mutual capacitance value between the electrode 21 and the electrode 22. This application changes the capacitance values of the first capacitance C_{2_2}, the second capacitance C_{2_3}, and the third capacitance C_{2_4} by designing parameters of the first electrode and the second electrode. When the external object 23 is a human body, the first capacitance C_{2_2}, the second capacitance C_{2_3} and the third capacitance C_{2_4} enable the first variation to be negative or positive. When the external object 23 is a non-human body, the first capacitance C_{2_2}, the second capacitance C_{2_3} and the third capacitance C_{2_4} enable second first variation to be positive or negative. The wearing state of the device can be accurately identified through the difference between the positive and negative variations.

Optionally, in the embodiment of the present application, the variation of the mutual capacitance value greater than zero can be referred to as a positive variation, and the variation of the mutual capacitance value less than zero can be referred to as a negative variation. Of course, the variation of the mutual capacitance value greater than zero can be referred to as a negative variation, and the variation of the mutual capacitance value less than zero can be referred to as a positive variation. The former is used for description below.

In the following, the non-human body is water or sweat as an example for description. Due to the difference in conductivity between the human body and the water or sweat, the equivalent capacitance C_{2_5} caused by the water or sweat is usually greater than the equivalent capacitance C_{2_5} caused by the human body. Therefore, the embodiment of the present application can satisfy the condition C_{2_5(human body)} < ΔC < C_{2_5(water/sweat)}, so that the variations (C_{2_5} - ΔC) of the mutual capacitance value caused by the human body and the water or sweat present a one positive and one negative state.

In this case, the variation of the mutual capacitance value greater than zero can be used to determine that the human body approaches the electronic device, and the variation of the mutual capacitance value less than zero can be used to determine that the human body does not approach the electronic device.

The detection module only needs to detect whether the variation of the mutual capacitance value is greater than zero or less than zero to determine whether the human body approaches the device or the non-human body approaches the device, which can accurately identify the wearing state of the device and is beneficial to reducing the misjudgment rate.

In the embodiment of the present application, at least one of the first capacitance C_{2_2}, the second capacitance C_{2_3}, and the third capacitance C_{2_4} can be adjusted to satisfy the condition C_{2_5(human body)} < ΔC < C_{2_5(water/sweat)}. For example, the magnitudes of the third capacitance C_{2_4} produced by the human body approaching the electronic device and the third capacitance C_{2_4} produced by the water or sweat approaching the electronic device can be adjusted to satisfy C_{2_5(human body)} < ΔC < C_{2_5(water/sweat)}, or the magnitudes of the first capacitance C_{2_2} and second capacitance C_{2_3} produced by the human body approaching the electronic device and the first capacitance C_{2_2} and second capacitance C_{2_3} produced by the water or sweat approaching the electronic device can be adjusted to satisfy C_{2_5(human body)} < ΔC < C_{2_5(water/sweat)}.

The magnitude of the equivalent capacitance C_{2_5} is related to the magnitudes of the first capacitance C_{2_2}, the second capacitance C_{2_3}, and the third capacitance C_{2_4}, which is expressed by a function as C_{2_5} = *f*(C_{2_2}, C_{2_3}, C_{2_4}), where *f* represents a function relationship. According to the experimental data, the equivalent capacitance C2_5 decreases with the increase of the third capacitance C_{2_4}, and decreases with the decrease of the first capacitance C_{2_2} and the second capacitance C_{2_3}. When the third capacitance C_{2_4} is infinite (equivalent to ideal grounding of the external object 23), the equivalent capacitance C2_5 decreases to 0; and when any of the first capacitance C_{2_2} and the second capacitance C_{2_3} is close to 0, the equivalent capacitance C_{2_5} is also close to 0.

The third capacitances C_{2_4} produced by the human body and the water or sweat are different, usually C_{2_4 (human body)} > C_{2_4 (water/sweat)}, so that the equivalent capacitances C_{2_5} produced by the human body and the water or sweat are different. Since the equivalent capacitance C_{2_5} is inversely proportional to the third capacitance C_{2_4}, C_{2_5(human body)} < C_{2-5(water/sweat)}. Therefore, the magnitudes of the third capacitances C_{2_4} produced by the human body and the water or sweat can be adjusted to satisfy the condition C_{2_5(human body)} < C_{2_5(water/sweat)}, so that the variations (C_{2_5} - ΔC) of the mutual capacitance value caused by the human body and the water or sweat present a one positive and one negative state, thereby improving the distinction between the human body and the water or sweat.

The equivalent capacitance C_{2_5} is not only related to the third capacitance C_{2_4}, but also related to the sum of the first capacitance C_{2_2} and the second capacitance C_{2_3}, and the equivalent capacitance C_{2_5} is directly proportional to (C_{2_2} + C_{2_3}). Generally, for a determined electronic device, the third capacitances C_{2_4} of the human body and the water or sweat to the ground can be regarded as determined values, and **Fehler!** = k > 1 is assumed.

Assuming that the human body and the water or sweat approach the electronic device in the same area and shape, that is, the first capacitances C_{2_2} and the second capacitances C_{2_3} caused by the human body approaching the electronic device and the water or sweat approaching the electronic device are the same, then the ratio of the equivalent capacitances C_{2_5} produced by the two is **Fehler!** = m = *g*[*k*, (C_{2_2} + C_{2_3})], where g represents a function relationship. Given that k is determined, m increases with the decrease of (C_{2_2} + C_{2_3}), and decreases with the increase of (C_{2_2} + C_{2_3}). When (C_{2_2} + C_{2_3}) is close to 0, m is close to k; and when (C_{2_2} + C_{2_3}) is infinite, m is close to 1, that is, 1 < m < k.

The greater the value of m is, the greater the difference between the equivalent capacitances C_{2_5} produced by the human body and the water or sweat is, and the easier the distinction in the approaching of the human body and the water or sweat is. The smaller the value of m is, the smaller the difference between the equivalent capacitances C_{2_5} produced by the human body and the water or sweat is, and the more difficult the distinction in the approaching of the human body and the water or sweat is. From the above analysis, it can be seen that the reduction in the first capacitance C_{2_2} and the second capacitance C_{2_3} can increase the value of m, that is, increase the difference between the equivalent capacitances C_{2_5} produced by the human body and the water or sweat. Therefore, in the embodiment of the present application, the first capacitance C_{2_2} and the second capacitance C_{2_3} can be reduced to achieve the purpose that the variations of the mutual capacitance value caused by the approaching of the human body and the approaching of the water or sweat are just in opposite directions.

However, when the values of the first capacitance C_{2_2} and the second capacitance C_{2_3} are reduced, the value of C_{2_1} is also reduced, that is, the original mutual capacitance decrease ΔC increases, and both the equivalent capacitance C_{2_5(human body)} and the equivalent capacitance C_{2_5(water/sweat)} may be less than the original mutual capacitance decrease ΔC. Therefore, in the embodiment of the present application, when the first capacitance C_{2_2} and the second capacitance C_{2_3} are reduced, the change in the original mutual capacitance decrease ΔC is also considered.

Therefore, in the embodiment of the present application, the magnitudes of the first capacitance C_{2_2}, the second capacitance C_{2_3}, and the original mutual capacitance decrease ΔC can be changed, so that C_{2_5(human body)} < ΔC < C_{2_5(water/sweat)}. Specifically, in the embodiment of the present application, the parameters of the electrode 21 and the electrode 22 can be changed to change the magnitudes of the first capacitance C_{2_2}, the second capacitance C_{2_3}, and the original mutual capacitance decrease ΔC.

The parameters of the electrode 21 and the electrode 22 can include at least one of a coupling length, gap and distance between the electrode 21 and the electrode 22, and an area of the electrodes.

Optionally, the first electrode and the second electrode can be arranged on the same plane; or the first electrode and the second electrode are arranged in parallel and the first electrode is arranged above the second electrode, wherein projections of the first electrode and the second electrode in a direction perpendicular to a surface of the first electrode do not overlap, or projections of a part of the second electrode and the first electrode in a direction perpendicular to a surface of the first electrode overlap. As such, when an external object approaches the electronic device, in the approaching direction facing the human body, the first electrode does not shield the second electrode or only partially shields the second electrode to ensure that both the first electrode and the second electrode can form a capacitance with the external object.

The first electrode is arranged above the second electrode, indicating that the first electrode is arranged closer to the external object than the second electrode, that is, the distance between the first electrode and the external object is smaller than the distance between the second electrode and the external object.

The projections of a part of the second electrode and the first electrode in a direction perpendicular to a surface of the first electrode overlapping indicates that the first electrode above will not completely shield the second electrode below, and both the first electrode and the second electrode can form a capacitance with the external object.

Preferably, the first electrode and the second electrode can be arranged on the same plane, or the first electrode and the second electrode are arranged in parallel and the projections of the first electrode and the second electrode in the direction perpendicular to the surface of the first electrode do not overlap. As such, when the human body approaches the electronic device, the first electrode and the second electrode directly face the human body and will not be shielded by the other electrode, and the capacitance value of the capacitance formed between the first electrode and the human body and the capacitance value of the capacitance formed between the second electrode and the human body are easier to control.

More preferably, the first electrode and the second electrode can be arranged on the same plane. As such, the mutual capacitance value between the first electrode and the second electrode is relatively large, which is beneficial to improving the accuracy of the detection result that the human body approaches the electronic device.

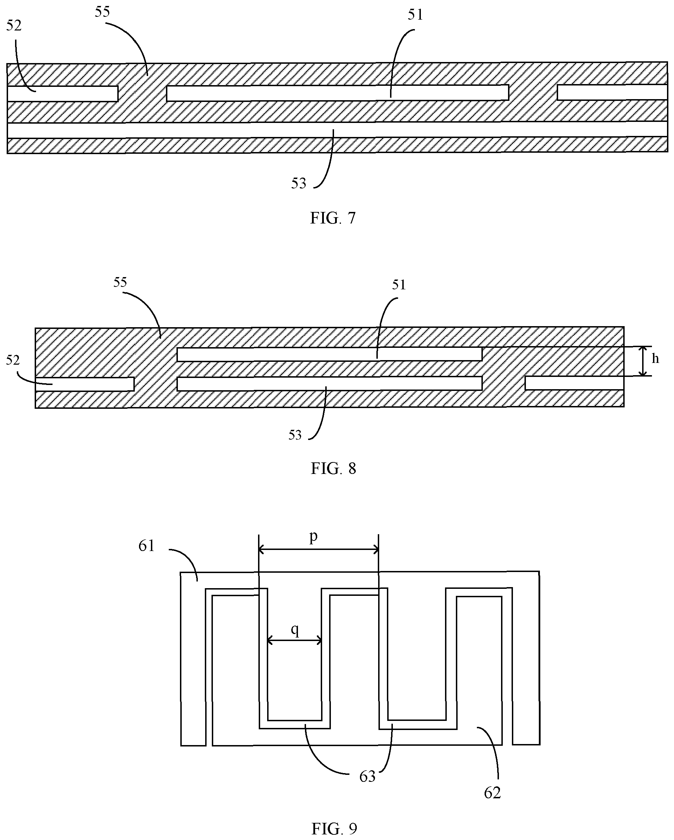

When the first electrode and the second electrode are arranged in parallel, in order to ensure the amount of signals sensed between the first electrode and the second electrode, the distance between the first electrode and the second electrode cannot be too large. In the embodiment of the present application, the distance between the first electrode and the second electrode can be less than 100 µm. Taking FIG. 8 as an example, the distance h between the first electrode 51 and the second electrode 52 is less than 100 µm.

The structure of the first electrode and the second electrode will be described in detail below with reference to FIGS. 5 to 10.

Coupling lines between the first electrode and the second electrode can be non-straight, for example, the coupling lines can be in the shape of rings, square waves, or curves, which can increase the coupling length between the first electrode and the second electrode and increase the amount of signals sensed between the first electrode and the second electrode in a limited space.

Taking FIGS. 5 and 6 as an example, the first electrode 51 and the second electrode 52 can be arranged in a ring-shaped pattern, that is, the second electrode 52 surrounds the first electrode 51.

Compared with straight coupling lines, the arrangement in a ring-shaped pattern can increase the coupling length between the first electrode 51 and the second electrode 52, and can thus increase the amount of signals sensed between the first electrode and the second electrode.

The first electrode can be arranged in a middle area of the second electrode, and the second electrode is of a ring structure surrounding the first electrode.

Understandably, the solution that the second electrode surrounds the first electrode in the embodiment of the present application can indicate that the second electrode surrounds the first electrode on a plane coplanar with the first electrode, or the second electrode surrounds the first electrode on a plane parallel to the first electrode. The pattern formed by the projections of the first electrode and the second electrode in the direction perpendicular to the surface of the first electrode is the projection of the second electrode surrounding the projection of the first electrode.

Preferably, the second electrode can be co-centered with the first electrode. The concentrical first electrode and second electrode ensure that the gap between the two electrodes at different positions is equal, so that no matter at which position the external object approaches the electronic device, the signal sensing amount between the first electrode and the second electrode can be more uniform, that is, when the external object is at the same distance from the electronic device but at different positions, the first electrode and the second electrode have the same signal sensing amount.

For example, the first electrode is of a square structure, and the second electrode is of a square ring structure that surrounds the first electrode and is concentrical as the first electrode, as shown in FIGS. 5 and 6. For another example, the first electrode is of a circular structure, and the second electrode is of a circular ring structure that surrounds the first electrode and is concentrical with the first electrode. Of course, the first electrode and the second electrode can also be of other shapes and structures.

Preferably, the first electrode 51 can be of a rectangular structure. As shown in FIG. 6, the first electrode 51 has a size of L × W, where L ≥ W.

Generally, a substrate carrying the approaching detection apparatus is rectangular, that is, the electrodes are usually arranged on the substrate, and the substrate is of a rectangular structure. Therefore, the rectangular electrodes can improve the space utilization of the substrate. In addition, considering that the approaching area of the human body approaching the electronic device is usually rectangular, the rectangular electrodes can further more fully sense the influence of the human body approaching on mutual capacitance signals.

In addition, the width of the second electrode can be greater than or equal to the gap between the first electrode and the second electrode. As shown in FIG. 6, the width e of the second electrode is greater than or equal to the gap d between the first electrode and the second electrode. This ensures a relatively small difference between an absolute value when the variation of the mutual capacitance value is a positive value and an absolute value when the variation of the mutual capacitance value is a negative value, that is, the original mutual capacitance decrease ΔC is almost an intermediate value of the equivalent capacitance C_{2_5(human body)} and the equivalent capacitance C_{2_5(water/sweat)}, thereby improving the accuracy of the detection result that the human body approaches the electronic device.

If the space of the electronic device is limited, e≥0.2mm can also be selected to ensure the amount of signals sensed between the second electrode and the human body.

The gap between the first electrode and the second electrode cannot be too large. Taking FIG. 6 as an example, the gap d between the first electrode 51 and the second electrode 52 is preferably between L/6 and L/4, which ensures the relatively small difference between the absolute value when the variation of the mutual capacitance value is a positive value and the absolute value when the variation of the mutual capacitance value is a negative value, that is, the original mutual capacitance decrease ΔC is almost an intermediate value of the equivalent capacitance C_{2_5(human body)} and the equivalent capacitance C_{2_5(water/sweat)}, thereby improving the accuracy of the detection result that the human body approaches the electronic device.

Arranging the first electrode 51 and the second electrode 52 into a homocentric-squares structure can increase the coupling length between the first electrode 51 and the second electrode 52, the coupling length being about a perimeter of the first electrode 51, which is beneficial to increasing the signal amount of inductive capacitance between the first electrode 51 and the second electrode 52, and improves the accuracy of the detection result that the human body approaches the electronic device.

There is a gap between the first electrode and the second electrode, and the gap can be equal at different positions. As shown in FIG. 5, d1 = d2. As such, no matter at which position the external object approaches the electronic device, it can be ensured that the first electrode and the second electrode have identical signal sensing amount, and whether the external object approaches the electronic device can be accurately identified.

After the structure of the electronic device is given, the total size of the mutual capacitance electrodes is usually fixed. For example, a headset has relatively small size and internal space, the space for the corresponding electrodes is relatively limited. For example, in FIG. 5, the outer contour of the electrode 52 is determined. If the gap 54 is increased, the area of the electrode 51 will decrease, and the second capacitance C_{2_3} produced after the external object approaches will also decrease. According to the principle described above, the decrease in the second capacitance C_{2_3} results in an increase in the equivalent capacitance C_{2_5} produced by the approaching of the external object, so that the value of m increases, that is, the difference between the equivalent capacitances C_{2_5} produced by the human body and the water or sweat increases, which helps to distinguish the approaching of the human body and the water or sweat. In the present application, the gap 54 between the first electrode 51 and the second electrode 52 can be adjusted, so that C_{2_5(human body)} < ΔC < C_{2_5(water/sweat)}.

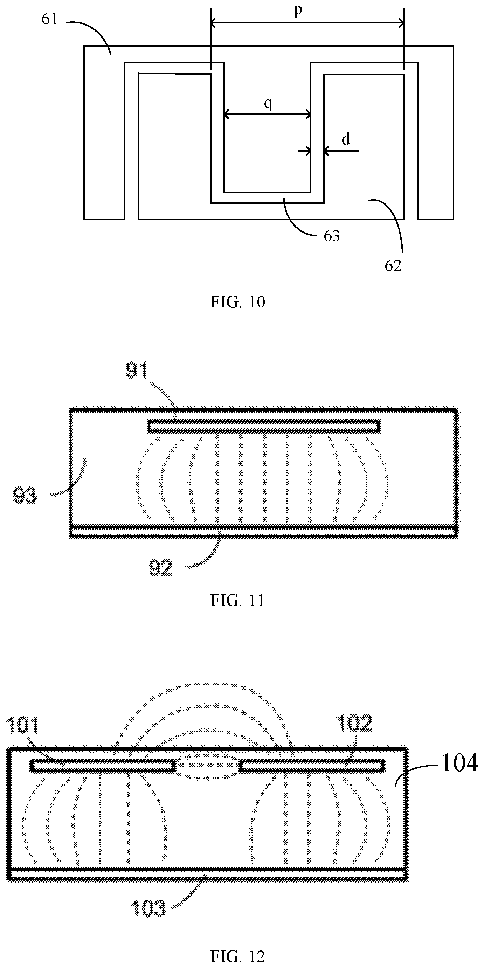

In addition to the above homocentric-squares structure, the first electrode and the second electrode can also be arranged in a meshing structure. Because the meshing structure can also increase the coupling length between the first electrode and the second electrode, the amount of signals sensed between the first electrode and the second electrode can increase. FIGS. 9 and 10 show schematic diagrams of coupling lines in a square wave shape.

The first electrode includes a first toothed structure, the second electrode includes a second toothed structure, and the first toothed structure meshes with the second toothed structure.

Tooth widths of the first toothed structure and the second toothed structure can be equal, so that the amounts of signals sensed between the first electrode and the human body and between the second electrode and the human body can be equal.

The gap between the first electrode and the second electrode is q/3 to q/2, where q is the tooth width of the first electrode or the second electrode, as shown in FIG. 10. This ensures a relatively small difference between an absolute value when the variation of the mutual capacitance value is a positive value and an absolute value when the variation of the mutual capacitance value is a negative value, that is, the original mutual capacitance decrease ΔC is almost an intermediate value of the equivalent capacitance C_{2_5(human body)} and the equivalent capacitance C_{2_5(water/sweat)}, thereby improving the accuracy of the detection result that the human body approaches the electronic device.

In the embodiment of the application, parameters such as the number of teeth of the first electrode and the second electrode, the tooth width q, the tooth pitch p, and the gap d between the two electrodes can be adjusted so that C_{2_5(human body)} < ΔC < C_{2_5(water/sweat)}.

In the case of limited space, the greater the number of teeth is, the smaller the tooth width is, which is not conducive to the processing and installation of the first electrode and the second electrode. On this basis, the number of teeth in the embodiment of the present application can be not more than 5. Preferably, the number of teeth of the first electrode and the second electrode can be 2 or 3.

FIG. 9 shows a case where the first electrode 61 and the second electrode 62 include three teeth. FIG. 10 shows a case where the first electrode 61 and the second electrode 62 include two teeth.

Taking FIG. 9 as an example, under normal circumstances, after the structure of the electronic device is fixed, the total size of the electrode 61 and the electrode 62 is fixed, that is, the size of the outer contour of the electrode 61 is fixed. According to the above analysis, if the gap between the electrode 61 and the electrode 62 is increased, the area of the electrode 62 will be reduced. After the external object approaches the electrode, the second capacitance C_{2_3} between the external object and the electrode 62 will be reduced, which will increase the difference between the equivalent capacitances produced by the approaching of the human body and the water or sweat.

Preferably, the first toothed structure and the second toothed structure have an equal tooth width. The equal tooth width of the two toothed structures can ensure that the first electrode and the second electrode have an equal area, so that the first electrode and the second electrode have an equal signal sensing amount with the human body.

Preferably, taking FIG. 10 as an example, the gap d between the first electrode 61 and the second electrode 62 can be between q/3 and q/2, where q is the tooth width of the first electrode or the second electrode. This ensures a relatively small difference between an absolute value when the variation of the mutual capacitance value is a positive value and an absolute value when the variation of the mutual capacitance value is a negative value, thereby improving the accuracy of the detection result that the human body approaches the electronic device.

Increasing the number of teeth can increase the coupling length between the first electrode 61 and the second electrode 62, thereby increasing the amount of signals sensed between the first electrode 61 and the second electrode 62. After the structure of the electronic device is fixed, the increase in the number of teeth will reduce the tooth width, which is not conducive to the manufacturing and installation of the electrodes. Therefore, the specific number of teeth and the tooth width can be adjusted according to actual needs.

In addition to the arrangement of the first electrode 61 and the second electrode 62 on the same plane as shown in FIGS. 9 and 10, the first electrode 61 and the second electrode 62 can also be arranged in parallel, and the first electrode 61 is arranged above the second electrode. 62. The projections of the first electrode 61 and the second electrode 62 in the direction perpendicular to the surface of the first electrode 61 do not overlap, or the projections of a part of the second electrode 62 and the first electrode in the direction perpendicular to the surface of the first electrode 61 overlap, to ensure that the first electrode 61 above does not shield or only partially shield the second electrode 62 below, and both the first electrode 61 and the second electrode 62 can form a capacitance with the external object, so that the first electrode 61 and the second electrode 62 have a sufficient signal sensing amount with the external object.

However, in a case, after the gap between the first electrode and the second electrode is increased, the original mutual capacitance decrease ΔC between the first electrode 51 and the second electrode 52 is reduced, for example, after the gap 54 in FIG. 5 is increased, the reduction speed of the original mutual capacitance decrease ΔC is less than that of the equivalent capacitance C_{2_5}. As a result, the equivalent capacitances C_{2_5} produced when the human body and the water or sweat approach are smaller than the original mutual capacitance decrease ΔC. On this basis, the embodiment of the present application proposes a further solution, which ensures C_{2_5(human body)} < ΔC < C_{2_5(water/sweat)}.

The approaching detection apparatus further include a third electrode, and the third electrode is arranged under the first electrode and in a plane parallel to the first electrode.

Since the third electrode can absorb some electric field lines between the first electrode and the second electrode, it is easier to achieve the purpose that the variations in the mutual capacitance value caused by the approaching of the human body and the approaching of the non-human body are just in opposite directions.

The third electrode can be grounded, or connected to a fixed level, or suspended. Preferably, the third electrode is grounded or connected to a fixed level, so that the electric field lines between the first electrode and the second electrode flow to the ground or the fixed level through the third electrode. However, the third electrode can also be suspended, indicating that the third electrode is not connected to any level. In this case, the third electrode can form a capacitance structure with other device in the electronic device, and the capacitance structure also affects the electric field lines between the first electrode and the second electrode.

Optionally, the projection of the third electrode in a direction perpendicular to a surface of the third electrode covers the projections of the first electrode and the second electrode in this direction,
or the projection of the third electrode in a direction perpendicular to a surface of the third electrode at least fully covers the projection of the gap between the first electrode and the second electrode in this direction, which is beneficial to increasing the influence of the third electrode on the original mutual capacitance decrease ΔC.

The projection of the third electrode covers the projection of the gap between the first electrode and the second electrode, which can ensure that the third electrode has a sufficient influence on the electric field lines between the first electrode and the second electrode.

Taking FIG. 6 as an example, the first electrode is the electrode 51, the second electrode is the electrode 52, and the third electrode is the electrode 53. When the mutual capacitance value between the electrode 51 and the electrode 52 is detected, since some electric field lines between the electrode 51 and the electrode 52 are absorbed by the electrode 53, the addition of the electrode 53 can significantly increase the reduction speed of the original mutual capacitance decrease ΔC with the increase of the gap 54, that is, the larger the gap 54 is, the more electric field lines absorbed by the electrode 53 is, the easier the C_{2_5(human body)} < ΔC < C_{2_5(water/sweat)} is.

In order to ensure the above-mentioned influence of the third electrode on the electric field lines between the first electrode and the second electrode, the distance between the third electrode and the first electrode or the second electrode cannot be too large, for example, the distance can be less than or equal to 200 µm. Preferably, the distance is less than or equal to 100 µm.

As a way, in FIG. 7, the first electrode 51 and the second electrode 52 can be arranged in the same plane, the third electrode 53 is arranged below the first electrode 51, and the projection of the third electrode 53 in the direction perpendicular to the surface of the third electrode at least covers the projection of the gap between the first electrode 51 and the second electrode 52 in this direction, which can ensure that the third electrode better absorbs the electric field lines between the first electrode and the second electrode.

Optionally, the projection of the third electrode 53 in the direction perpendicular to the surface of the third electrode completely covers the first electrode 51 and the second electrode 52, and an edge of the third electrode 53 is aligned with an edge of the second electrode, which is beneficial to the encapsulation of the first electrode, the second electrode, and the third electrode.

As another way, the first electrode and the second electrode can be arranged in parallel, the second electrode is of a ring structure surrounding the first electrode, and the second electrode is arranged below the first electrode. In this case, the third electrode can be arranged on the same plane as the second electrode.

As shown in FIG. 8, the first electrode 51 and the second electrode 52 are arranged in parallel, the second electrode 52 is of a ring structure surrounding the first electrode 51, and the projections of the first electrode 51 and the second electrode 52 in the direction perpendicular to the surface of the first electrode 51 do not overlap. The distance between the first electrode 51 and the second electrode 52 is less than 100 µm, to ensure the amount of signals sensed between the first electrode 51 and the second electrode 52.

The third electrode 53 and the second electrode 52 are arranged on the same plane. In this structure, the third electrode 53 can also increase the reduction speed of the original mutual capacitance decrease ΔC with the increase of the gap, so that C_{2_5(human body)} < ΔC < C_{2_5(water/sweat)} is easier to achieve.

Preferably, the third electrode 53 can be arranged in a middle area of the second electrode 52, and the third electrode 53 and the second electrode 53 are concentrical, which can ensure that the third electrode 53 has the same influence on the electric field lines at different positions between the first electrode 51 and the second electrode 52.

Of course, a third electrode is also be added to the meshing electrode structure shown in FIGS. 9 and 10, so that C_{2_5(human body)} < ΔC < C_{2_5(water/sweat)} is easier to achieve.

The first electrode, the second electrode, and the third electrode in the embodiments of the present application can be arranged in a substrate, and the substrate can be a printed circuit board (PCB) or a flexible printed circuit (FPC). As shown in FIGS. 7 and 8, the first electrode 51, the second electrode 52, and the third electrode 53 can be arranged in the substrate 55. If the substrate 55 is a PCB, the electrodes can be arranged on a top layer of the substrate.

When a mutual capacitance sensor improves the distinction between the human body and the water or sweat, the original mutual capacitance decrease ΔC is usually reduced to achieve C_{2_5(human body)} < ΔC < C_{2_5(water/sweat)}, which is more disadvantageous than self-capacitance detection in terms of signal size. For example, in some cases, the value of the original mutual capacitance decrease ΔC is close to the value of the equivalent capacitance C_{2_5(human body)}, that is, when the human body approaches the electronic device, the variation of the mutual capacitance value between the first electrode and the second electrode is relatively small, such as close to zero. At this time, no external object approaches the electronic device, or the human body approaches the electronic device.

On this basis, an embodiment of the present application further provides a solution that combines the advantages of self-capacitance detection and mutual-capacitance detection and adopts self-capacitance and mutual capacitance integrated detection, to further improve the accuracy of the detection result that the human body approaches the electronic device.

For example, whether the variation of the self-capacitance value reaches a threshold can be determined by means of self-capacitance detection, and whether the variation is caused by the approaching of a human body or a non-human body can be determined by means of mutual-capacitance detection.

Specifically, the variation of the self-capacitance value of the electrode can be detected first. If the variation of the self-capacitance value of the electrode reaches a preset threshold, it is determined that an external object approaches the electronic device. Then the variation of the mutual capacitance value can be further detected to determine whether the external object is a human body or a non-human body.

If the variation of the self-capacitance value of the electrode is less than the preset threshold, it is determined that no external object approaches the electronic device, and the variation of the mutual capacitance value of the electrode does not need to be further detected.

Taking a human body and water or sweat as an example, the variation of the self-capacitance value greater than the preset threshold and the variation of the mutual capacitance value greater than zero can be used to determine that the human body approaches the electronic device; and the variation of the self-capacitance value greater than the preset threshold and the variation of the mutual capacitance value less than zero can be used to determine that the human body does not approach the electronic device.

When the variation of the self-capacitance value is greater than the preset threshold, even if the variation of the mutual capacitance value is greater than zero and the variation is very small, it can be directly determined that the human body approaches the electronic device, which can improve the accuracy of the test result that the human body approaches the electronic device.

In the embodiment of the present application, the structures of the first electrode and the second electrode may not be changed. During self-capacitance detection, the self-capacitance value of the first electrode can be detected separately, or the self-capacitance value of the second electrode can be detected separately, or the total self-capacitance value of the first electrode and the second electrode as a whole can be detected, and whether an external object touches is determined according to the variation of the self-capacitance value.

In addition, in order to ensure a sufficient signal amount during self-capacitance detection, the area of the electrode can be greater than or equal to 3 mm². For example, if the self-capacitance value of the first electrode is detected, the area of the first electrode is greater than or equal to 3 mm².

In addition, the wearing detection apparatus according to the embodiment of the present application can also reduce the influence of temperature on the wearing detection result.

FIG. 11 shows a schematic diagram of a traditional self-capacitance detection apparatus. 91 is a self-capacitance electrode, and 92 is a system ground. The system ground 92 generally consists of a system ground on the FPC/PCB, a battery/antenna in the electronic device, and a system ground on the main board. Electric field lines (dashed lines in FIG. 11) between the electrode 91 and the system ground 92 are generally mainly distributed in a dielectric 93, and the dielectric 93 can be polyimide (PI), FR4, glue, etc. The dielectric constants of these dielectrics change with temperature, so the self-capacitance value between the electrode 91 and the system ground 92 also changes with the temperature, which will cause a problem of temperature drift.

FIG. 12 is a schematic diagram of a mutual capacitance detection apparatus according to an embodiment of the present application. The electrode 101 and the electrode 102 are two mutual capacitance electrodes, the electrode 103 is a system ground, the electrode 101 and the electrode 102 can be arranged in a substrate 104, the substrate 104 can be FPC or PCB, the electrode 101 and the electrode 102 can be preferably arranged on a top layer of the substrate 104, so that some electric field lines between the electrode 101 and the electrode 102 are distributed in the air, which can reduce the influence of the dielectric constant of the dielectric on the mutual capacitance between the two electrodes. In addition, because the temperature drift coefficient of air is extremely low, the mutual capacitance between the two electrodes is less affected by temperature than the self-capacitance detection apparatus, and the mutual capacitance detection can effectively suppress the temperature drift.

It should be noted that the terms used in the embodiments of the present application and the appended claims are only for the purpose of describing specific embodiments, and are not intended to limit the embodiments of the present application.

For example, the singular forms of "a", "the", "above-mentioned" and "this" used in the embodiments of the present application and the appended claims are also intended to include plural forms, unless the context clearly expresses other meanings.

Those skilled in the art can realize that the units and algorithm steps of the examples described in combination with the embodiments disclosed herein can be implemented by electronic hardware or a combination of computer software and electronic hardware. Whether these functions are executed by hardware or software depends on a specific application and design constraint conditions of the technical solution. Professionals can use different methods to implement the described functions for each specific application, but such implementation should not be considered beyond the scope of the embodiments of the present application.

If the functions are implemented in the form of software functional units and sold or used as independent products, the functions can be stored in a computer-readable storage medium. Based on such an understanding, the technical solution of the embodiments of the present application substantially, or the part of the technical solution making contribution to the prior art, or a part of the technical solution may be embodied in the form of a software product, and the computer software product is stored in a storage medium, which includes a plurality of instructions enabling a computer device (which may be a personal computer, a server, or a network device, etc.) to execute all of or part of the steps in the methods of the embodiments of the present application. The aforementioned storage medium includes various media capable of storing program codes, such as a U disk, a mobile hard disk, a read-only memory, a random access memory, a magnetic disk or an optical disk.

Those skilled in the art can clearly understand that, for the convenience and conciseness of description, the specific working processes of the above-mentioned devices, apparatuses and units can refer to the corresponding processes in the foregoing method embodiments, and details are not described herein again.

In several embodiments provided in the present application, it should be understood that the disclosed electronic device, apparatus, and method can be implemented in other ways.

For example, the division of units or modules or components in the apparatus embodiments described above is only a logical function division, and there may be other divisions during actual implementation. For example, a plurality of units or modules or components can be combined or integrated to another system, or some units or modules or components can be ignored or not executed.

For another example, the aforementioned units/modules/components described as separate/display components may or may not be physically separated, that is, they may be located in one place, or they may be distributed on a plurality of network units. Some or all of the units/modules/components may be selected according to actual needs to achieve the objectives of the embodiments of the present application.

Finally, it should be noted that the mutual coupling or direct coupling or communication connection shown or discussed above may be indirect coupling or communication connection through some interfaces, apparatuses or units, and may be in electrical, mechanical or other forms.

Described above are merely specific embodiments of the present application, but the protection scope of the present application is not limited thereto. Any skilled person who is familiar with this art could readily conceive of variations or substitutions within the technical scope disclosed by the embodiments of the present application, and these variations or substitutions shall fall within the protection scope of the present application. The scope of protection is defined by the appended claims.

## Claims

1. An approaching detection apparatus for an electronic device, comprising:
a first electrode (21, 51, 61), a second electrode (22, 52, 62), a third electrode (53), and a detection module (211) configured to detect a variation of a mutual capacitance value between the first electrode (21, 51, 61) and the second electrode (22, 52, 62), the variation of the mutual capacitance value being used to determine an approaching state of the electronic device, wherein when a human body approaches the electronic device, the variation of the mutual capacitance value is a first variation, and when a non-human body approaches the electronic device, the variation of the mutual capacitance value is a second variation, one of the first variation and the second variation being a positive value and the other of the first variation and the second variation being a negative value,
wherein, a first capacitance (C_{2_2}) is formed between the first electrode (21, 51, 61) and an external object (23), a second capacitance (C_{2_3}) is formed between the second electrode (22, 52, 62) and the external object (23), and a third capacitance (C_{2_4}) is formed between a system ground (20) and the external object (23), the external object (23) comprises the human body and the non-human body, and the first capacitance (C_{2_2}), the second capacitance (C_{2_3}), and the third capacitance (C_{2_4}) are configured such that one of the first variation and the second variation is enabled to be the positive value and the other of the first variation and the second variation is enabled to be the negative value;
wherein the first electrode (21, 51, 61) and the second electrode (22, 52, 62) are arranged in the same plane, and the third electrode (53) is arranged below the first electrode (21, 51, 61) and is parallel to the first electrode (21, 51, 61); wherein a distance between the third electrode (53) and the first electrode (21, 51, 61) is less than or equal to 200 µm, and the third electrode (53) is grounded or connected to a fixed level such that parts of electric field lines between the first electrode (21, 51, 61) and the second electrode (22, 52, 62) flow to the ground or the fixed level through the third electrode (53) to ensure that one of the first variation and the second variation is the positive value and the other of the first variation and the second variation is the negative value;
or, the first electrode (21, 51, 61) and the second electrode (22, 52, 62) are arranged in parallel, the first electrode (21, 51, 61) is arranged above the second electrode (22, 52, 62), and projections of the first electrode (21, 51, 61) and the second electrode (22, 52, 62) in a direction perpendicular to a surface of the first electrode (21, 51, 61) do not overlap, the third electrode (53) and the second electrode (22, 52, 62) are arranged in a same plane; wherein a distance between the third electrode (53) and the first electrode (21, 51, 61) is less than or equal to 100 µm, and the third electrode (53) is grounded or connected to a fixed level such that parts of electric field lines between the first electrode (21, 51, 61) and the second electrode (22, 52, 62) flow to the ground or the fixed level through the third electrode (53) to ensure that one of the first variation and the second variation is a positive value and the other of the first variation and the second variation is a negative value.

2. The apparatus according to claim 1, wherein the first electrode (21, 51, 61) and the second electrode (22, 52, 62) are arranged in the same plane;
the first electrode (21, 51, 61) is arranged in a middle area of the second electrode (22, 52, 62), and the second electrode (22, 52, 62) is of a ring structure surrounding the first electrode (21, 51, 61), or the first electrode (21, 51, 61) and the second electrode (22, 52, 62) are arranged in a meshing structure, the first electrode (21, 51, 61) comprises a first toothed structure, the second electrode (22, 52, 62) comprises a second toothed structure, and the first toothed structure meshes with the second toothed structure.

3. The apparatus according to claim 2, wherein the first electrode (21, 51, 61) is arranged in a middle area of the second electrode (22, 52, 62), and the second electrode (22, 52, 62) is of a ring structure surrounding the first electrode (21, 51, 61), the first electrode (21, 51, 61) and the second electrode (22, 52, 62) are concentrical.

4. The apparatus according to claim 3, wherein a width (e) of the second electrode (22, 52, 62) is greater than or equal to a gap (d) between the first electrode (21, 51, 61) and the second electrode (22, 52, 62).

5. The apparatus according to claim 3 or 4, wherein a gap (d) between the first electrode (21, 51, 61) and the second electrode (22, 52, 62) is L/6 to L/4, wherein L is a length of a long side of the first electrode (21, 51, 61).

6. The apparatus according to any one of claims 2-5, wherein a width (e) of the second electrode (22, 52, 62) is greater than or equal to 0.2 mm.

7. The apparatus according to claim 2, wherein the first electrode (21, 51, 61) and the second electrode (22, 52, 62) are arranged in a meshing structure, the first electrode (21, 51, 61) comprises a first toothed structure, the second electrode (22, 52, 62) comprises a second toothed structure, and the first toothed structure meshes with the second toothed structure, a gap (d) between the first electrode (21, 51, 61) and the second electrode (22, 52, 62) is q/3 to q/2, wherein q is the tooth width of the first electrode (21, 51, 61) or the second electrode (22, 52, 62).

8. The apparatus according to claim 7, wherein the first electrode (21, 51, 61) and the second electrode (22, 52, 62) are arranged in the same plane, and the third electrode (53) is arranged below the first electrode (21, 51, 61) and is parallel to the first electrode (21, 51, 61), projection of the third electrode (53) in a direction perpendicular to a surface of the third electrode (53) at least covers projection of a gap between the first electrode (21, 51, 61) and the second electrode (22, 52, 62) in the direction perpendicular to the surface of the third electrode (53).

9. The apparatus according to claim 8, wherein a distance between the third electrode (53) and the first electrode (21, 51, 61) is less than or equal to 200 µm.

10. The apparatus according to claim 1, wherein the first electrode (21, 51, 61) and the second electrode (22, 52, 62) are arranged in parallel, and the third electrode (53) and the second electrode (22, 52, 62) are arranged in the same plane, wherein a distance between the third electrode (53) and the first electrode (21, 51, 61) is less than or equal to 100 µm.

11. The apparatus according to any one of claims 1-10, wherein the detection module (211) is further configured to detect a variation of a self-capacitance value of the first electrode (21, 51, 61) and/or the second electrode (22, 52, 62), wherein it is determined that the external object (23) approaches the electronic device when the variation of the self-capacitance value is greater than a preset threshold, and the detection module (211) detects the variation of the mutual capacitance value between the first electrode (21, 51, 61) and the second electrode (22, 52, 62) when the variation of the self-capacitance value is greater than the preset threshold.

12. An electronic device, comprising:
the approaching detection apparatus according to any one of claims 1-11.

## Patentansprüche

1. Vorrichtung zur Annäherungsdetektion für ein elektronisches Gerät, umfassend:
eine erste Elektrode (21, 51, 61), eine zweite Elektrode (22, 52, 62), eine dritte Elektrode (53) und ein Detektionsmodul (211), das dazu konfiguriert ist, eine Änderung eines gegenseitigen Kapazitätswerts zwischen der ersten Elektrode (21, 51, 61) und der zweiten Elektrode (22, 52, 62) zu detektieren, wobei die Änderung des gegenseitigen Kapazitätswerts dazu verwendet wird, einen Annäherungszustand des elektronischen Geräts zu bestimmen, wobei, wenn sich ein menschlicher Körper dem elektronischen Gerät nähert, die Änderung des gegenseitigen Kapazitätswerts eine erste Änderung ist, und wobei, wenn sich ein nicht-menschlicher Körper dem elektronischen Gerät nähert, die Änderung des gegenseitigen Kapazitätswerts eine zweite Änderung ist, wobei eine der ersten Änderung und der zweiten Änderung ein positiver Wert und die andere der ersten Änderung und der zweiten Änderung ein negativer Wert ist,
wobei eine erste Kapazität (C_{2_2}) zwischen der ersten Elektrode (21, 51, 61) und einem externen Objekt (23) gebildet ist, eine zweite Kapazität (C_{2_3}) zwischen der zweiten Elektrode (22, 52, 62) und dem externen Objekt (23) gebildet ist, und eine dritte Kapazität (C_{2_4}) zwischen einer Systemerdung (20) und dem externen Objekt (23) gebildet ist, wobei das externe Objekt (23) den menschlichen Körper und den nicht-menschlichen Körper umfasst, und wobei die erste Kapazität (C_{2_2}), die zweite Kapazität (C_{2_3}) und die dritte Kapazität (C_{2_4}) so konfiguriert sind, dass eine der ersten Änderung und der zweiten Änderung den positiven Wert annehmen kann und die andere der ersten Änderung und der zweiten Änderung den negativen Wert annehmen kann;
wobei die erste Elektrode (21, 51, 61) und die zweite Elektrode (22, 52, 62) in derselben Ebene angeordnet sind, und die dritte Elektrode (53) unterhalb der ersten Elektrode (21, 51, 61) und parallel zu der ersten Elektrode (21, 51, 61) angeordnet ist; wobei ein Abstand zwischen der dritten Elektrode (53) und der ersten Elektrode (21, 51, 61) kleiner oder gleich 200 µm ist, und wobei die dritte Elektrode (53) geerdet ist oder mit einem festen Pegel verbunden ist, sodass Teile elektrischer Feldlinien zwischen der ersten Elektrode (21, 51, 61) und der zweiten Elektrode (22, 52, 62) durch die dritte Elektrode (53) zur Erde oder zum festen Pegel fließen, um sicherzustellen, dass eine der ersten Änderung und der zweiten Änderung der positive Wert ist und die andere der ersten Änderung und der zweiten Änderung der negative Wert ist; oder,
wobei die erste Elektrode (21, 51, 61) und die zweite Elektrode (22, 52, 62) parallel angeordnet sind, wobei die erste Elektrode (21, 51, 61) oberhalb der zweiten Elektrode (22, 52, 62) angeordnet ist, und wobei sich Projektionen der ersten Elektrode (21, 51, 61) und der zweiten Elektrode (22, 52, 62) in einer Richtung, die senkrecht zu einer Oberfläche der ersten Elektrode (21, 51, 61) verläuft, nicht überlappen, wobei die dritte Elektrode (53) und die zweite Elektrode (22, 52, 62) in derselben Ebene angeordnet sind; wobei ein Abstand zwischen der dritten Elektrode (53) und der ersten Elektrode (21, 51, 61) kleiner oder gleich 100 µm ist, und wobei die dritte Elektrode (53) geerdet ist oder mit einem festen Pegel verbunden ist, sodass Teile elektrischer Feldlinien zwischen der ersten Elektrode (21, 51, 61) und der zweiten Elektrode (22, 52, 62) durch die dritte Elektrode (53) zur Erde oder zum festen Pegel fließen, um sicherzustellen, dass eine der ersten Änderung und der zweiten Änderung ein positiver Wert und die andere der ersten Änderung und der zweiten Änderung ein negativer Wert ist.

2. Vorrichtung nach Anspruch 1, wobei die erste Elektrode (21, 51, 61) und die zweite Elektrode (22, 52, 62) in derselben Ebene angeordnet sind;
wobei die erste Elektrode (21, 51, 61) in einem mittleren Bereich der zweiten Elektrode (22, 52, 62) angeordnet ist, und die zweite Elektrode (22, 52, 62) eine die erste Elektrode (21, 51, 61) umgebende Ringstruktur aufweist, oder wobei die erste Elektrode (21, 51, 61) und die zweite Elektrode (22, 52, 62) in einer ineinandergreifenden Struktur angeordnet sind, die erste Elektrode (21, 51, 61) eine erste Zahnstruktur aufweist, die zweite Elektrode (22, 52, 62) eine zweite Zahnstruktur aufweist und die erste Zahnstruktur in die zweite Zahnstruktur eingreift.

3. Vorrichtung nach Anspruch 2, wobei die erste Elektrode (21, 51, 61) in einem mittleren Bereich der zweiten Elektrode (22, 52, 62) angeordnet ist und die zweite Elektrode (22, 52, 62) eine die erste Elektrode (21, 51, 61) umgebende Ringstruktur ist, wobei die erste Elektrode (21, 51, 61) und die zweite Elektrode (22, 52, 62) konzentrisch sind.

4. Vorrichtung nach Anspruch 3, wobei eine Breite (e) der zweiten Elektrode (22, 52, 62) größer oder gleich einem Spalt (d) zwischen der ersten Elektrode (21, 51, 61) und der zweiten Elektrode (22, 52, 62) ist.

5. Vorrichtung nach Anspruch 3 oder 4, wobei ein Spalt (d) zwischen der ersten Elektrode (21, 51, 61) und der zweiten Elektrode (22, 52, 62) L/6 bis L/4 beträgt, wobei L eine Länge einer Längsseite der ersten Elektrode (21, 51, 61) darstellt.

6. Vorrichtung nach einem der Ansprüche 2 bis 5, wobei eine Breite (e) der zweiten Elektrode (22, 52, 62) größer oder gleich 0,2 mm ist.

7. Vorrichtung nach Anspruch 2, wobei die erste Elektrode (21, 51, 61) und die zweite Elektrode (22, 52, 62) in einer ineinandergreifenden Struktur angeordnet sind, wobei die erste Elektrode (21, 51, 61) eine erste Zahnstruktur umfasst, die zweite Elektrode (22, 52, 62) eine zweite Zahnstruktur umfasst, und die erste Zahnstruktur in die zweite Zahnstruktur eingreift, wobei ein Spalt (d) zwischen der ersten Elektrode (21, 51, 61) und der zweiten Elektrode (22, 52, 62) q/3 bis q/2 beträgt, wobei q eine Zahnbreite der ersten Elektrode (21, 51, 61) oder der zweiten Elektrode (22, 52, 62) darstellt.

8. Vorrichtung nach Anspruch 7, wobei die erste Elektrode (21, 51, 61) und die zweite Elektrode (22, 52, 62) in derselben Ebene angeordnet sind, und die dritte Elektrode (53) unterhalb der ersten Elektrode (21, 51, 61) und parallel zu der ersten Elektrode (21, 51, 61) angeordnet ist, wobei eine Projektion der dritten Elektrode (53) in einer Richtung, die senkrecht zu einer Oberfläche der dritten Elektrode (53) verläuft, eine Projektion eines Spalts zwischen der ersten Elektrode (21, 51, 61) und der zweiten Elektrode (22, 52, 62) in der Richtung, die senkrecht zu der Oberfläche der dritten Elektrode (53) verläuft, zumindest abdeckt.

9. Vorrichtung nach Anspruch 8, wobei ein Abstand zwischen der dritten Elektrode (53) und der ersten Elektrode (21, 51, 61) kleiner oder gleich 200 µm ist.

10. Vorrichtung nach Anspruch 1, wobei die erste Elektrode (21, 51, 61) und die zweite Elektrode (22, 52, 62) parallel angeordnet sind, und die dritte Elektrode (53) und die zweite Elektrode (22, 52, 62) in der gleichen Ebene angeordnet sind, wobei ein Abstand zwischen der dritten Elektrode (53) und der ersten Elektrode (21, 51, 61) kleiner oder gleich 100 µm ist.

11. Vorrichtung nach einem der Ansprüche 1 bis 10, wobei das Detektionsmodul (211) ferner dazu konfiguriert ist, eine Änderung eines Eigenkapazitätswerts der ersten Elektrode (21, 51, 61) und/oder der zweiten Elektrode (22, 52, 62) zu detektieren, wobei es bestimmt wird, dass sich das externe Objekt (23) dem elektronischen Gerät nähert, wenn die Änderung des Eigenkapazitätswerts größer als ein voreingestellter Schwellenwert ist, und wobei das Detektionsmodul (211) die Änderung des gegenseitigen Kapazitätswerts zwischen der ersten Elektrode (21, 51, 61) und der zweiten Elektrode (22, 52, 62) detektiert, wenn die Änderung des Eigenkapazitätswerts größer als der voreingestellte Schwellenwert ist.

12. Elektronisches Gerät, umfassend:
die Vorrichtung zur Annäherungsdetektion nach einem der Ansprüche 1 bis 11.

## Revendications

1. Dispositif de détection d'approche pour un équipement électronique, comprenant
une première électrode (21, 51, 61), une deuxième électrode (22, 52, 62), une troisième électrode (53) et un module de détection (211) configuré pour détecter une variation d'une valeur de capacité mutuelle entre la première électrode (21, 51, 61) et la deuxième électrode (22, 52, 62), la variation de la valeur de capacité mutuelle étant utilisée pour déterminer un état d'approche de l'équipement électronique, dans lequel lorsqu'un corps humain s'approche de l'équipement électronique, la variation de la valeur de capacité mutuelle est une première variation, et lorsqu'un corps non humain s'approche de l'équipement électronique, la variation de la valeur de capacité mutuelle est une deuxième variation, l'une de la première variation et la deuxième variation étant une valeur positive et l'autre de la première variation et la deuxième variation étant une valeur négative,
dans lequel, une première capacité (C_{2_2}) est formée entre la première électrode (21, 51, 61) et un objet externe (23), une deuxième capacité (C_{2_3}) est formée entre la deuxième électrode (22, 52, 62) et l'objet externe (23), et une troisième capacité (C_{2_4}) est formée entre une terre de système (20) et l'objet externe (23), l'objet externe (23) comprend le corps humain et le corps non humain, et la première capacité (C_{2_2}), la deuxième capacité (C_{2_3}), et la troisième capacité (C_{2_4}) sont configurées pour que l'une de la première variation et de la deuxième variation puisse être une valeur positive et l'autre de la première variation et la deuxième variation puisse être une valeur négative ;
dans lequel la première électrode (21, 51, 61) et la deuxième électrode (22, 52, 62) sont disposées dans le même plan, et la troisième électrode (53) est disposée sous la première électrode (21, 51, 61) et est parallèle à la première électrode (21, 51, 61) ; dans lequel une distance entre la troisième électrode (53) et la première électrode (21, 51, 61) est inférieure ou égale à 200 µm, et la troisième électrode (53) est mise à la terre ou connectée à un niveau fixe de sorte que des parties de lignes de champ électrique entre la première électrode (21, 51, 61) et la deuxième électrode (22, 52, 62) s'écoulent vers la terre ou le niveau fixe à travers la troisième électrode (53) pour s'assurer que l'une de la première variation et de la deuxième variation est une valeur positive et l'autre de la première variation et de la deuxième variation est une valeur négative ;
ou, la première électrode (21, 51, 61) et la deuxième électrode (22, 52, 62) sont disposées en parallèle, la première électrode (21, 51, 61) est disposée au-dessus de la deuxième électrode (22, 52, 62), et des projections de la première électrode (21, 51, 61) et de la deuxième électrode (22, 52, 62) dans une direction perpendiculaire à une surface de la première électrode (21, 51, 61) ne se chevauchent pas, la troisième électrode (53) et la deuxième électrode (22, 52, 62) sont disposées dans le même plan ; dans lequel une distance entre la troisième électrode (53) et la première électrode (21, 51, 61) est inférieure ou égale à 100 µm, et la troisième électrode (53) est mise à la terre ou connectée à un niveau fixe de sorte que des parties de lignes de champ électrique entre la première électrode (21, 51, 61) et la deuxième électrode (22, 52, 62) s'écoulent vers la terre ou le niveau fixe à travers la troisième électrode (53) pour s'assurer que l'une de la première variation et de la deuxième variation est une valeur positive et l'autre de la première variation et de la deuxième variation est une valeur négative.

2. Dispositif selon la revendication 1, dans lequel la première électrode (21, 51, 61) et la deuxième électrode (22, 52, 62) sont disposées dans le même plan ;
la première électrode (21, 51, 61) est disposée dans une zone médiane de la deuxième électrode (22, 52, 62), et la deuxième électrode (22, 52, 62) est une structure annulaire entourant la première électrode (21, 51, 61), ou la première électrode (21, 51, 61) et la deuxième électrode (22, 52, 62) sont disposées dans une structure d'engrènement, la première électrode (21, 51, 61) comprend une première structure dentée, la deuxième électrode (22, 52, 62) comprend une deuxième structure dentée et la première structure dentée s'engrène avec la deuxième structure dentée.

3. Dispositif selon la revendication 2, dans lequel la première électrode (21, 51, 61) est disposée dans une zone médiane de la deuxième électrode (22, 52, 62), et la deuxième électrode (22, 52, 62) est une structure annulaire entourant la première électrode (21, 51, 61), la première électrode (21, 51, 61) et la deuxième électrode (22, 52, 62) sont concentriques.

4. Dispositif selon la revendication 3, dans lequel une largeur (e) de la deuxième électrode (22, 52, 62) est supérieure ou égale à un espace (d) entre la première électrode (21, 51, 61) et la deuxième électrode (22, 52, 62).

5. Dispositif selon la revendication 3 ou 4, dans lequel un espace (d) entre la première électrode (21, 51, 61) et la deuxième électrode (22, 52, 62) est de L/6 à L/4, dans lequel L est une longueur d'un côté long de la première électrode (21, 51, 61).

6. Dispositif selon l'une quelconque des revendications 2 à 5, dans lequel une largeur (e) de la deuxième électrode (22, 52, 62) est supérieure ou égale à 0,2 mm.

7. Dispositif selon la revendication 2, dans lequel la première électrode (21, 51, 61) et la deuxième électrode (22, 52, 62) sont disposées dans une structure d'engrènement, la première électrode (21, 51, 61) comprend une première structure dentée, la deuxième électrode (22, 52, 62) comprend une deuxième structure dentée, et la première structure dentée s'engrène avec la deuxième structure dentée, un espace (d) entre la première électrode (21, 51, 61) et la deuxième électrode (22, 52, 62) est de q/3 à q/2, où q est une largeur de dent de la première électrode (21, 51, 61) ou de la deuxième électrode (22, 52, 62).

8. Dispositif selon la revendication 7, dans lequel la première électrode (21, 51, 61) et la deuxième électrode (22, 52, 62) sont disposées dans le même plan, et la troisième électrode (53) est disposée sous de la première électrode (21, 51, 61) et est parallèle à la première électrode (21, 51, 61), une projection de la troisième électrode (53) dans une direction perpendiculaire à une surface de la troisième électrode (53) recouvre au moins une projection d'un espace entre la première électrode (21, 51, 61) et la deuxième électrode (22, 52, 62) dans la direction perpendiculaire à la surface de la troisième électrode (53).

9. Dispositif selon la revendication 8, dans lequel une distance entre la troisième électrode (53) et la première électrode (21, 51, 61) est inférieure ou égale à 200 µm.

10. Dispositif selon la revendication 1, dans lequel la première électrode (21, 51, 61) et la deuxième électrode (22, 52, 62) sont disposées en parallèle, et la troisième électrode (53) et la deuxième électrode (22, 52, 62) sont disposées dans le même plan, dans lequel une distance entre la troisième électrode (53) et la première électrode (21, 51, 61) est inférieur ou égal à 100 µm.

11. Dispositif selon l'une quelconque des revendications 1 à 10, dans lequel le module de détection (211) est en outre configuré pour détecter une variation d'une valeur d'auto-capacité de la première électrode (21, 51, 61) et/ou de la deuxième électrode (22, 52, 62), dans lequel il est déterminé que l'objet externe (23) s'approche de l'équipement électronique lorsque la variation de la valeur d'auto-capacité est supérieure à un seuil prédéfini, et le module de détection (211) détecte la variation de la valeur de capacité mutuelle entre la première électrode (21, 51, 61) et la deuxième électrode (22, 52, 62) lorsque la variation de la valeur de capacité propre est supérieure au seuil prédéfini.

12. Équipement électronique, comprenant :
le dispositif de détection d'approche selon l'une quelconque des revendications 1 à 11.
